(19) Europäisches Patentamt
European Patent Office
Office européen des brevets

(11) **EP 2 932 803 B1**

(12) **EUROPÄISCHE PATENTSCHRIFT**

(45) Veröffentlichungstag und Bekanntmachung des Hinweises auf die Patenterteilung:
**02.01.2019 Patentblatt 2019/01**

(51) Int Cl.:
*H05K 1/02* *(2006.01)*     *H05K 1/11* *(2006.01)*
*H05K 3/10* *(2006.01)*

(21) Anmeldenummer: **13782711.9**

(22) Anmeldetag: **24.10.2013**

(86) Internationale Anmeldenummer:
**PCT/EP2013/072227**

(87) Internationale Veröffentlichungsnummer:
**WO 2014/090473 (19.06.2014 Gazette 2014/25)**

(54) **KONTAKTANORDNUNG FÜR EINEN MEHRLAGIGEN SCHALTUNGSTRÄGER**

CONTACT ARRANGEMENT FOR A MULTI-LAYER CIRCUIT BOARD

SYSTÈME DE CONTACT POUR SUPPORT DE CIRCUIT MULTICOUCHE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.12.2012 DE 102012223077**

(43) Veröffentlichungstag der Anmeldung:
**21.10.2015 Patentblatt 2015/43**

(73) Patentinhaber: **Robert Bosch GmbH**
**70442 Stuttgart (DE)**

(72) Erfinder: **SCHAEFER, Rainer**
**71679 Asperg (DE)**

(56) Entgegenhaltungen:
**EP-A1- 1 004 226     DE-A1-102006 053 697**
**US-A- 4 500 389     US-A1- 2002 170 744**

**Beschreibung**

Stand der Technik

Die Erfindung geht aus von einer Kontaktanordnung für einen mehrlagigen Schaltungsträger nach der Gattung des unabhängigen Patentanspruchs 1, der insbesondere für Hochstromanwendungen geeignet ist.

Üblicherweise umfassen Kontaktanordnungen für einen mehrlagigen Schaltungsträger ein Kontaktelement und eine Aussparung, welche mindestens eine innenliegende Metalllage bzw. eine innenliegende stromführende Schicht, welche als Metallblech und/oder als sogenanntes Inlay ausgeführt ist, des mehrlagigen Schaltungsträgers freilegt. Zur Außenkontaktierung ist das Kontaktelement über die Aussparung mit der mindestens einen innenliegenden Metalllage bzw. der stromführenden Schicht elektrisch leitend verbunden. Die elektrisch leitende Verbindung kann beispielsweise über Löten und/oder Schrauben und/oder Nieten hergestellt werden.

Aus der US 4,500,389 A ist eine Kontaktanordnung für einen mehrlagigen Schaltungsträger bekannt, welcher mindestens einen innenliegenden Draht aufweist. Der Draht ist über mindestens eine Aussparung kontaktiert ist, wobei mindestens zwei Aussparungen auf verschiedenen Seiten des mindestens einen innenliegenden Drahts angeordnet sind. Die Mittelachsen der mindestens zwei Aussparungen weisen einen vorgegebenen Abstand zu einer Sollmittellinie des mindestens einen innenliegenden Drahts auf, wobei die mindestens zwei Aussparungen den mindestens einen innenliegenden Draht zur Kontaktierung freilegen. In den Aussparungen ist mindestens ein Kontaktelement angeordnet.

In der Patentschrift DE 101 08 168 C1 wird ein Verfahren zur Herstellung einer drahtbeschriebenen Leiterplatte sowie eine solche drahtbeschriebene Leiterplatte beschrieben. Auf einer Innenseite eines dünnen Flächenelements aus elektrisch leitendem Material der Drahtverschreibung werden Leitungsdrähte definiert verlegt und an definierten Kontaktstellen des Flächenelements befestigt und kontaktiert. Anschließend wird auf der Innenseite des Flächenelements mit den kontaktierten Leitungsdrähten ein Stabilisierungsflächenelement flächig festgelegt. Danach wird das dünne Flächenelement von seiner Außenseite her derartig strukturiert, dass die Kontaktstellen vom übrigen Flächenelement getrennt und somit elektrisch isoliert werden. Derartige Leiterplatten geringer Dicke können zu einer kompakten Mehrlagenschaltung zusammen gebaut werden. Um eine elektrische Verbindung zwischen den drahtbeschriebenen Leiterplatten eines mehrlagigen Schaltungsträger zu schaffen, können Durchkontaktierungen im Bereich der definierten Kontaktstellen seitlich neben den Drähten vorgesehen werden.

Offenbarung der Erfindung

Die erfindungsgemäße Kontaktanordnung für einen mehrlagigen Schaltungsträger mit den Merkmalen des unabhängigen Patentanspruchs 1 hat demgegenüber den Vorteil, dass mindestens ein innenliegender Draht direkt an zwei unterschiedlichen Seiten von außen kontaktiert werden kann. In vorteilhafter Weise kann auf eine stromführende Schicht zur Außenkontaktierung des Drahts verzichtet werden. Des Weiteren kann ein innerer Kontaktbereich zwischen einer stromführenden Schicht und dem mindestens einen Draht in vorteilhafter Weise in einem andern Bereich des Drahts als der Kontaktbereich für die Außenkontaktierung des Drahts realisiert werden. Somit können in vorteilhafter Weise die inneren Kontaktbereiche und die Außenkontaktierungen des Drahts unabhängig voneinander im Schaltungsträger angeordnet werden. Des Weiteren können Leistungsverluste durch die direkte Kontaktierung des Drahts in vorteilhafter Weise minimiert werden. Da ein Draht in der Regel einen höheren Strom tragen kann als die stromführende Schicht, mit welcher der Draht verbunden ist, können in vorteilhafter Weise höhere Ströme von außen auf den Schaltungsträger übertragen werden. Somit kann in vorteilhafter Weise eine zuverlässige Hochstromaußenkontaktierung des Schaltungsträgers geschaffen werden.

Ausführungsformen der vorliegenden Erfindung stellen eine Kontaktanordnung für einen mehrlagigen Schaltungsträger zur Verfügung, welcher vorzugsweise für Hochstromanwendungen eingesetzt wird. Der Schaltungsträger weist mindestens einen innenliegenden Draht auf, welcher über mindestens eine Aussparung kontaktiert ist. Mindestens zwei Aussparungen werden auf verschiedenen Seiten des mindestens einen innenliegenden Drahts angeordnet, wobei die Mittelachsen der mindestens zwei Aussparungen einen vorgegebenen Abstand zu einer Sollmittellinie des mindestens einen innenliegenden Drahts aufweisen. Die mindestens zwei Aussparungen legen den mindestens einen innenliegenden Draht zur Kontaktierung an mindestens zwei Kontaktbereichen frei, wobei die mindestens zwei Kontaktbereiche auf verschiedenen Seiten des Drahts angeordnet sind.

Erfindungsgemäß ist das jeweilige Kontaktelement in die korrespondierende Aussparung eingepresst und/oder eingelötet. Dies ermöglicht eine kostengünstige und zuverlässige Außenkontaktierung des mindestens einen innenliegenden Drahts, welcher über die Aussparung freigelegt ist. In vorteilhafter Weise kann beim Einpressen aufgrund der Kaltverschweißung eine stoffschlüssige Verbindung mit der Lochhülse bzw. der elektrisch leitenden Wandung und somit über die Hülse bzw. Wandung ein direkter Zugang zum innenliegenden Draht entstehen. Beim Löten kann der direkte Zugang über das Lot geschaffen werden. Auf diese Weise kann das Kontaktelement direkt und/oder indirekt zuverlässig mit dem korrespondierenden Kontaktbereich des mindestens einen innenliegenden Drahts verbunden und/oder gekoppelt werden, wobei diese Verbindung und/oder Kopplung in vorteilhafter Weise für Hochstromanwendungen geeignet ist.

Unter einer Sollmittellinie wird nachfolgend die Linie verstanden, welche den Verlauf der Drahtmitte innerhalb des Schaltungsträgers wiederspiegelt. Wird der Draht beispielsweise mit einer rechteckig ausgeführten stromführenden Schicht verbunden, dann verläuft die Sollmittellinie vorzugsweise entlang einer Mittelachse der stromführenden Schicht, so dass der Draht mittig auf der rechteckig ausgeführten stromführenden Schicht angeordnet ist.

Durch die mindestens zwei Aussparungen ist eine direkte Kontaktierung des mindestens einen Drahts möglich, wobei in vorteilhafter Weise eine verbesserte Außenkontaktierung ermöglicht werden kann. Dadurch können insbesondere drahtbeschriebene Schaltungsträger kontaktiert werden, wobei die Außenkontaktierung höheren Temperaturen besser standhalten kann, als beispielsweise eine Kontaktierung über eine stromführende Schicht, auf welcher der innenliegende Draht angeordnet ist. Des Weiteren kann in vorteilhafter Weise der innenliegende Draht an beliebigen Bereichen des Schaltungsträgers freigelegt und kontaktiert werden. Des Weiteren kann in vorteilhafter Weise eine Engstelle zwischen einem Kontaktelement und dem innenliegenden Draht, wie sie bei üblichen Kontaktanordnungen vorkommt und ein damit verbundener erhöhter ohmscher Widerstand am Kontaktbereich verhindert werden. Die mindestens zwei Aussparungen des Schaltungsträgers zur Kontaktierung des innenliegenden Drahts können beispielsweise einfach und kostengünstig durch Fräsen und/oder Laserbearbeitung und/oder Bohren und/oder Ätzen hergestellt werden.

Durch die in den abhängigen Ansprüchen aufgeführten Maßnahmen und Weiterbildungen sind vorteilhafte Verbesserungen der im unabhängigen Patentanspruch 1 angegebenen Kontaktanordnung für einen mehrlagigen Schaltungsträger möglich.

Besonders vorteilhaft ist, dass der vorgegebene Abstand der Mittelachsen der mindestens zwei Aussparungen zur Sollmittellinie des mindestens einen innenliegenden Drahts entsprechend einer Toleranzschwankung des mindestens einen innenliegenden Drahts zur Sollmittellinie reduziert wird. In vorteilhafter Weise kann der vorgegebene Abstand der Mittelachsen zur Sollmittellinie so gewählt werden, dass der Draht unabhängig von den Toleranzschwankungen an dem vorgegeben Kontaktbereich frei gelegt wird. Um eine Außenkontaktierung des innenliegenden Drahts ohne Berücksichtigung der Toleranzschwankungen zu ermöglichen, entspricht der maximal mögliche Abstand der Mittelachse einer Aussparung zur Sollmittellinie der halben Breite der Aussparung plus der halben Drahtbreite. Unter Berücksichtigung der Toleranzschwankungen wird der maximal mögliche Abstand der Mittelachse einer Aussparung zur Sollmittellinie um die mögliche Toleranzschwankung reduziert, so dass in vorteilhafter Weise eine sichere Freilegung des innenliegenden Drahts gewährleistet wird, auch wenn dieser nicht exakt mittig zur Sollmittellinie ausgerichtet ist. Zusätzlich kann ein weiterer Überlappungsbereich als Teil der Toleranzschwankung berücksichtigt werden, damit auch im Extremfall, d.h. der innenliegende Draht ist auf der Toleranzgrenze angeordnet, eine Überlappung der Aussparung mit dem innenliegenden Draht gewährleistet ist.

In vorteilhafter Ausgestaltung der erfindungsgemäßen Kontaktanordnung kann der Abstand zwischen den Mittelachsen der mindestens zwei Aussparungen, bei vorgegeben Abstand der einzelnen Aussparungen zur Sollmittellinie, über einen Ausrichtwinkel variiert werden. Der Ausrichtwinkel kann hierbei variiert werden indem die Mittelachsen der Aussparungen parallel zur Sollmittellinie verschoben werden. Der Ausrichtwinkel kann dem Winkel zwischen der Sollmittellinie und der direkten Verbindungslinie zwischen den Mittelachsen der Aussparungen entsprechen. Der Abstand zwischen den Mittelachsen der Aussparungen ist minimal, wenn der Ausrichtwinkel zwischen der Sollmittellinie und der direkten Verbindungslinie zwischen den Mittelachsen der Aussparungen einen Wert von 90° aufweist. In diesem Fall sind die Mittelachsen gegenüberliegend zu einander angeordnet.

In weiterer vorteilhafter Ausgestaltung der erfindungsgemäßen Kontaktanordnung können die Wandungen der Aussparungen elektrisch leitfähig ausgeführt werden. Dies kann beispielsweise über eine Metallisierung der Aussparung und/oder über das Einfügen einer elektrisch leitenden Lochhülse in die Aussparung erfolgen. Die Metallisierung der Aussparung kann beispielsweise durch einen galvanischen Prozess hergestellt werden. Durch die elektrisch leitfähige Wandung kann eine direkte Kontaktierung des innenliegenden Drahts und der korrespondierenden stromführenden Schicht hergestellt werden. Dadurch dass die Wandungen der Aussparung elektrisch leitfähig ausgeführt sind, kann eine einfache Kontaktierung des innenliegenden Drahts erfolgen, welcher von der elektrisch leitenden Wand im Kontaktbereich berührt bzw. überlappt wird.

In weiterer vorteilhafter Ausgestaltung der erfindungsgemäßen Kontaktanordnung können die mindestens zwei Aussparungen im Bereich eines Drahtendes des mindestens einen innenliegenden Drahts angeordnet werden.

In weiterer vorteilhafter Ausgestaltung der erfindungsgemäßen Kontaktanordnung kann mindestens eine Aussparung zwischen zwei innenliegenden Drähten angeordnet werden und beide innenliegende Drähte kontaktieren. Dadurch kann in vorteilhafter Weise eine Verbindung zwischen zwei innenliegenden Drähten hergestellt werden. Zudem kann die mindestens eine Aussparung auch zwei in verschiedenen Ebenen des Schaltungsträgers angeordnete innenliegende Drähte gleichzeitig elektrisch kontaktieren. Des Weiteren kann Material und/oder Layoutfläche eingespart werden, wenn eine Aussparung zwei innenliegende Drähte zur Außenkontaktierung mit dem gleichen Potential freilegt.

In weiterer vorteilhafter Ausgestaltung der erfindungsgemäßen Kontaktanordnung kann jeweils ein Kontaktelement innerhalb einer Aussparung angeordnet werden. In vorteilhafter Weise kann das Kontaktelement über die Aussparung mit dem mindestens einen innenliegenden Draht elektrisch leitend verbunden werden. In vorteilhafter Weise sind eine formschlüssige und/oder eine kraftschlüssige Verbindung des Kontaktelements mit dem freigelegten Kontaktbereich des Drahts ausreichend, so dass auf weitere Kontaktierungen verzichtet werden kann. Da die Wandung der Aussparung elektrisch leitend ausgeführt und mit dem freigelegten Kontaktbereich des Drahts verbunden ist, kontaktiert das Kontaktelement den Draht in vorteilhafter Weise indirekt über die elektrisch leitende Wandung.

In weiterer vorteilhafter Ausgestaltung der erfindungsgemäßen Kontaktanordnung können zwei Kontaktelemente über einen Steg miteinander verbunden werden und einen Doppelpin ausbilden. In vorteilhafter Weise können über einen Doppelpin größere Ströme auf den Draht übertragen und/oder die Stromleitfähigkeit der Kontaktanordnung verbessert werden.

In weiterer vorteilhafter Ausgestaltung der erfindungsgemäßen Kontaktanordnung kann der Abstand zwischen den Mittelachsen der mindestens zwei Aussparungen über den Ausrichtwinkel an einen vorgegeben Abstand zwischen den Kontaktelementen des Doppelpins angepasst werden. In vorteilhafter Weise kann eine Ausführung eines Doppelpins mit einer vorgegeben Steglänge und einem vorgegebenen Abstand zwischen den Kontaktelementen zur Kontaktierung eines innenliegenden Drahts verwendet werden, indem der Abstand zwischen den Mittelachsen der Aussparungen an den benötigten Abstand zwischen den Kontaktelementen angepasst wird. In vorteilhafter Weise kann eine Ausführung des Doppelpins in verschiedenen Schaltungsträgern zur Außenkontaktierung des innenliegenden Drahts und/oder der innenliegenden Drähte verwendet werden, wobei die Fertigung der Kontaktanordnung durch die Minimierung der Ausführungsformen der Doppelpins erleichtert werden kann, da eine Ausführungsform des Doppelpins durch eine Schrägstellung der Aussparungen zur Außenkontaktierung von verschiedenen innenliegende Drähten verwendet werden kann, welche beispielsweise verschiedene Breiten aufweisen.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

Kurze Beschreibung der Zeichnungen

Fig. 1 zeigt einen schematischen Querschnitt eines ersten Ausführungsbeispiels eines mehrlagigen Schaltungsträgers mit einer erfindungsgemäßen Kontaktanordnung.

Fig. 2 zeigt einen schematischen Querschnitt des ersten Ausführungsbeispiels eines mehrlagigen Schaltungsträgers mit einer erfindungsgemäßen Kontaktanordnung entlang der Linie II-II in Fig. 1.

Fig. 3 zeigt einen schematischen Querschnitt eines zweiten Ausführungsbeispiels eines mehrlagigen Schaltungsträgers mit einem zweiten Ausführungsbeispiel einer erfindungsgemäßen Kontaktanordnung.

Fig. 4 zeigt einen schematischen Querschnitt eines dritten Ausführungsbeispiels eines mehrlagigen Schaltungsträgers mit einer dritten Ausführungsform der erfindungsgemäßen Kontaktanordnung.

Fig. 5 zeigt einen schematischen Querschnitt eines vierten Ausführungsbeispiels eines mehrlagigen Schaltungsträgers mit einem vierten Ausführungsbeispiel einer erfindungsgemäßen Kontaktanordnung.

Ausführungsformen der Erfindung

Mehrlagige Schaltungsträger umfassen in der Regel mindestens eine innenliegende stromführende Schicht, über welche ein mit dem Schaltungsträger verbundenes Bauelement mit Strom versorgt wird. Um die Stromtragfähigkeit des mehrlagigen Schaltungsträgers zu erhöhen, umfasst der mehrlagige Schaltungsträger innenliegende Drähte, welche beispielsweise auf die innenliegende stromführende Schicht aufgebracht sind. Die innenliegende stromführende Schicht kann hierbei beispielsweise als Kupferfolie ausgeführt werden. Schaltungsträger, welche zur Erhöhung der Stromtragfähigkeit, Drähte aufweisen werden üblicherweise als drahtbeschriebene Leiterplatte bezeichnet.

Übliche Kontaktanordnungen für einen mehrlagigen drahtbeschriebenen Schaltungsträger, welcher mindestens einen innenliegenden Draht aufweist, umfassen mindestens eine Aussparung, über welche eine innenliegende stromführende Schicht des Schaltungsträgers kontaktiert ist, welche mit dem innenliegenden Draht elektrisch leitend verbunden ist. Alternativ wird die innenliegende stromführende Schicht, mit welcher der innenliegende Draht verbunden ist, in einem Kontaktbereich über die Aussparung nach außen und von dem Bereich, der mit dem innenliegenden Draht verbunden ist, weggeführt, wobei der herausragende Teil der stromführenden Schicht von außen kontaktiert wird. Mit der stromführenden Schicht wird der mit der stromführenden Schicht verbundene innenliegende Draht kontaktiert.

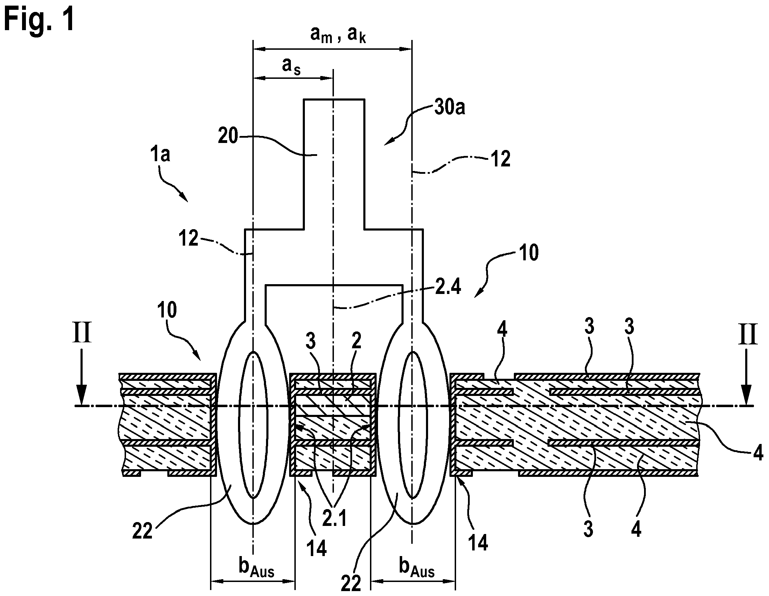

Wie aus Fig. 1 bis 5 ersichtlich ist, umfassen die dargestellten Ausführungsbeispiele eines mehrlagigen Schaltungsträgers 1a, 1b, 1c, 1d jeweils mindestens eine innenliegende stromführende Schicht 3. Die mindestens eine innenliegende stromführende Schicht 3 ist vorzugsweise als Metallfolie, insbesondere als Kupferfolie ausgeführt. Anstelle von Kupfer kann auch ein anderes Material mit ähnlich guten elektrischen und thermischen Leitfähigkeiten verwendet werden. Um die Stromtragfähigkeit des mehrlagigen Schaltungsträgers 1a, 1b, 1c, 1d zu erhöhen, umfasst der mehrlagige Schaltungsträgers 1a, 1b, 1c, 1d mindestens einen innenliegenden elektrisch leitfähigen Draht 2, welcher beispielsweise auf die mindestens eine innenliegende stromführende Schicht 3 aufgebracht ist. Der mindestens eine innenliegende Draht 3 ist insbesondere dafür geeignet, hohe Ströme, wie sie beispielsweise bei Hochstromanwendungen vorkommen, zu transportieren. Des Weiteren kann der innenliegende Draht 3 zylinderförmig oder quaderförmig ausgeführt werden. Der innenliegende Draht 3 kann des Weiteren eine nicht dargestellte isolierende Umhüllung aufweisen, wobei die isolierende Umhüllung des innenliegenden Drahts 3 an den vorgegebenen inneren Kontaktbereichen 3.1 mit der innenliegenden stromführenden Schicht 3 ausgespart ist. Zudem kann der innenliegende Draht 3 Teil eines im Schaltungsträger 1a, 1b, 1c, 1d angeordneten Drahtgitters sein.

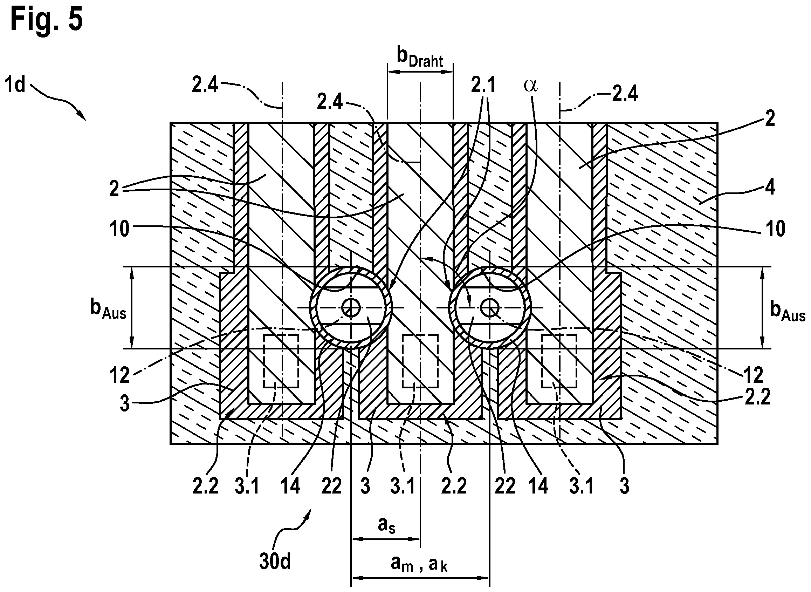

Die in Fig. 1 bis 4 dargestellten Ausführungsbeispiele eines mehrlagigen Schaltungsträgers 1a, 1b, 1c zeigen jeweils einen innenliegenden Draht 2, welcher auf einer korrespondierenden innenliegenden stromführenden Schicht 3 angeordnet ist. Das in Fig. 5 dargestellte Ausführungsbeispiel eines mehrlagigen Schaltungsträgers 1d zeigt drei innenliegende Drähte 2, welche jeweils auf einer innenliegenden stromführenden Schicht 3 angeordnet sind.

Wie aus Fig. 1 bis 5 weiter ersichtlich ist, sind die innenliegenden Drähte 2 jeweils an einem ersten Kontaktbereich 3.1 mit einer korrespondierenden innenliegenden stromführenden Schicht 3 elektrisch leitend verbunden. In einer bevorzugen Ausführungsform ist der erste Kontaktbereich 3.1 als Schweißpunkt ausgeführt, wobei die innenliegende stromführende Schicht 3 im Bereich des ersten Kontaktbereichs 3.1 breiter als im weiteren Verlauf ausgeführt ist. Des Weiteren ist die mindestens eine stromführende Schicht 3 und der korrespondierende innenliegende Draht 2 zwischen organischen Substraten einlaminiert, welche isolierende Schichten 4 ausbilden. Eine Oberfläche des mehrlagigen Schaltungsträgers 1a, ist wie in Fig. 1 dargestellt ist, strukturiert ausgeführt und weist elektrisch leitende Schichten 3 bzw. Bereiche und elektrisch isolierende Schichten 4 bzw. Bereiche auf.

Wie aus Fig. 1 bis 5 weiter ersichtlich ist, umfasst eine Kontaktanordnung 30a, 30b, 30c, 30d für den mehrlagigen Schaltungsträger 1a, 1b, 1c, 1d jeweils mindestens eine Aussparung 10, welche die innenliegende stromführende Schicht 3 des mehrlagigen Schaltungsträgers 1a, 1b, 1c, 1d freigelegt.

Erfindungsgemäß weist die Kontaktanordnung 30a, 30b, 30c, 30d mindestens zwei Aussparungen 10 auf, welche an verschiedenen Seiten des mindestens einen innenliegenden Drahts 2 angeordnet sind, wobei die Mittelachsen 12 der mindestens zwei Aussparungen 10 einen vorgegebenen Abstand $a_s$ zu einer Sollmittellinie 2.4 des mindestens einen innenliegenden Drahts 2 aufweisen.

Die Sollmittellinie 2.4 ist als die Linie definiert, welche den Sollverlauf des Drahts 2 innerhalb des Schaltungsträgers 1a, 1b, 1c, 1d wiederspiegelt, wobei die Mitte des Drahts 2 im Idealfall deckungsgleich auf der Sollmittellinie 2.4 verläuft. Das bedeutet, dass der Draht 2 mit einer Breite b die Sollmittellinie 2.4 im Idealfall auf beiden Seiten der Sollmittellinie 2.4 gleich überlappt.

In bevorzugten in Fig. 1 bis 5 dargestellten Ausführungsformen, sind der Draht 2 und die stromführenden Schicht 3 achsensymmetrisch zur Sollmittlinie 2.4 ausgerichtet. In dargestellten Ausführungsbeispielen ist der Draht 2 mit einer rechteckig ausgeführten stromführenden Schicht 3 verbunden, wobei die Sollmittellinie 2.4 entlang einer Mittelachse der stromführenden Schicht 3 verläuft, so dass der Draht 2 mittig auf der rechteckig ausgeführten stromführenden Schicht 3 angeordnet ist.

Die mindestens zwei Aussparungen 10 legen den mindestens einen innenliegenden Draht 2 zur Außenkontaktierung an mindestens zwei weiteren Kontaktbereichen 2.1 frei, wobei die Kontaktbereiche 2.1 auf verschiedenen Seiten des Drahts 2 angeordnet sind.

Wie aus Fig. 1 bis 5 ersichtlich ist, ist der vorgegebene Abstand $a_s$ der Mittelachsen 12 in den dargestellten Ausführungsbeispielen für beide Aussparungen 10 gleich groß. Somit berechnet sich ein maximaler Abstand $a_{smax}$ zwischen der Mittelachse 12 der jeweiligen Aussparung 10 und der Sollmittellinie 2.4 ohne Toleranzschwankung gemäß Gleichung (1). Der maximale Abstand $a_{smax}$ wird ohne Toleranzschwankung so bestimmt, dass die jeweilige Aussparung 10 den innenliegenden Draht 2 am vorgegebenen Kontaktbereich 2.1 gerade noch freilegt.

$$a_{s\,max} = \left( \frac{1}{2} b_{Draht} + \frac{1}{2} b_{Aus} \right) \qquad (1)$$

Hierbei repräsentiert $b_{Draht}$ die Breite bzw. den Durchmesser des innenliegenden Drahts 2 und $b_{Aus}$ repräsentiert die Breite bzw. den Durchmesser der Aussparung 10.

Um eine sichere Freilegung des Drahts 2 zu ermöglichen, auch wenn dieser nicht exakt mittig zur Sollmittellinie 2.4 ausgerichtet ist, wird der maximal mögliche Abstand $a_{smax}$ um den Betrag der Toleranzschwankung $\Delta a$ reduziert, um welche die Mitte des innenliegenden Drahts 2 von der Sollmittellinie 2.4 abweichen kann. Somit ergibt sich der Abstand zwischen der Mittelachse 12 der jeweiligen Aussparung 10 und der Sollmittellinie 2.4 gemäß Gleichung (2).

$$a_s = a_{s\,max} - \Delta a = \left( \frac{1}{2} b_{Draht} + \frac{1}{2} b_{Aus} \right) - |\Delta a| \qquad (2)$$

Somit berücksichtigt der vorgegebene Abstand $a_s$ der Mittelachsen 12 zur Sollmittellinie 2.4 des mindestens einen innenliegenden Drahts 2 bei den dargestellten Ausführungsbeispielen die Toleranzschwankung des mindestens einen innenliegenden Drahts 2 zur Sollmittellinie 2.4. Die innenliegenden Drähte 2 können beispielsweise eine Breite $b_{Draht}$ von ungefähr 1,4mm aufweisen. Diese Drähte 2 können mit einer Toleranzschwankung $\Delta a$ von ungefähr +/- 0,2mm zur Sollmittellinie 2.4 verlegt werden. Die Berücksichtigung der Toleranzschwankung bei der Bestimmung des vorgegebenen Abstands $a_s$ der Mittelachsen 12 zur Sollmittellinie 2.4 gewährleistet eine Freilegung des Drahts 2, selbst wenn dieser nicht exakt auf der Sollmittellinie 2.4 verläuft. Zusätzlich kann ein weiterer Überlappungsbereich ü als Teil der Toleranzschwankung berücksichtigt werden, damit auch im Extremfall, d.h. der innenliegende Draht 2 ist auf der Toleranzgrenze angeordnet, eine Überlappung der Aussparung 10 mit dem innenliegenden Draht 2 gewährleistet ist. Im dargestellten Ausführungsbeispiel kann der zusätzliche Überlappungsbereich ü beispielsweise 0,1 mm betragen, so dass im oben angegebenen Zahlenbeispiel insgesamt ein Betrag von 0,3mm als Toleranzschwankung $\Delta a$ berücksichtigt wird.

Wie aus Fig. 1 bis 5 weiter ersichtlich ist, sind die Wandungen der Aussparungen 10 elektrisch leitfähig ausgeführt. In den dargestellten Ausführungsbeispielen wird die Wandung von einer elektrisch leitfähigen Lochhülse 14 ausgebildet, welche den innenliegenden Draht 2 im korrespondierenden Kontaktbereich 2.1 berührt.

Wie aus Fig. 1 bis 5 weiter ersichtlich ist, weist die Kontaktanordnung 30a, 30b, 30c, 30d zwei Kontaktelemente 22 auf, wobei jeweils ein Kontaktelement 22 innerhalb einer Aussparungen 10 angeordnet ist. Das Kontaktelement 22 ist hierbei in die korrespondierende Aussparung 10 eingepresst und/oder eingelötet. Des Weiteren sind die Kontaktelemente 22 über einen Steg 24 miteinander verbunden und bilden einen Doppelpin 20 aus. Die in Fig. 1 dargestellten Kontaktelemente 22 sind hohl ausgeführt und weisen eine Elastizität auf, so dass die Kontaktelemente 22 beim Einführen in die Aussparung 10 nachgeben und mit einer vorgegebenen Kraft gegen die Wandung der Lochhülse 14 drücken können.

Die in den Fig. 1 bis 5 dargestellten Schaltungsträger 1a, 1b, 1c, 1d unterscheiden sich durch die Ausführung und/oder durch die Position der jeweiligen Kontaktanordnung 30a, 30b, 30c und 30d.

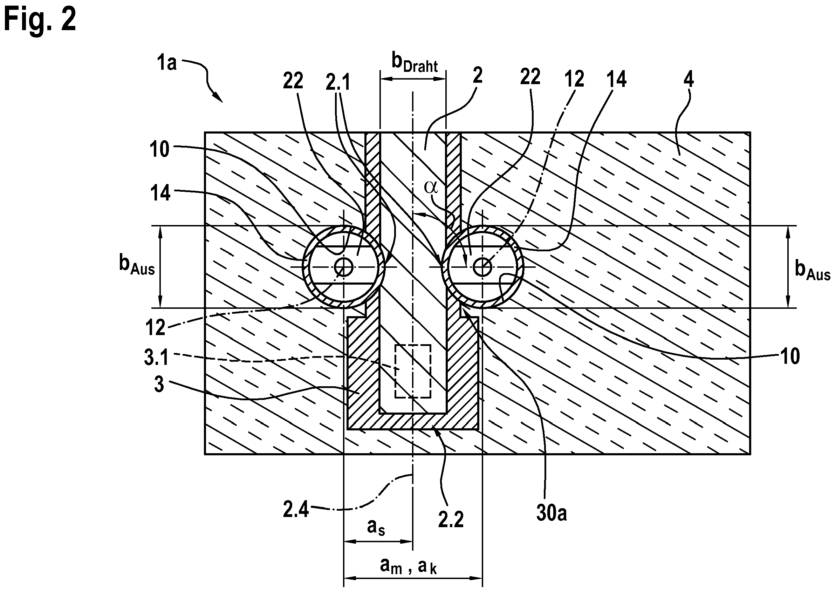

Das in Fig. 1 und 2 dargestellte erste Ausführungsbeispiel des Schaltungsträgers 1a weist eine Kontaktanordnung 30a auf, deren Aussparungen 10 vor dem Endbereich 2.2 des innenliegenden Drahts 2 mit einem Ausrichtwinkel $\alpha$ von 90° zwischen der Sollmittellinie 2.4 und der direkten Verbindungslinie zwischen den Mittelachsen 12 der Aussparungen 10 ausgerichtet sind. Durch den Ausrichtwinkel $\alpha$ von 90° ist der Abstand $a_m$ zwischen den Mittelachsen 12 der beiden Aussparungen 10 minimal und die Aussparungen 10 liegen sich gegenüber.

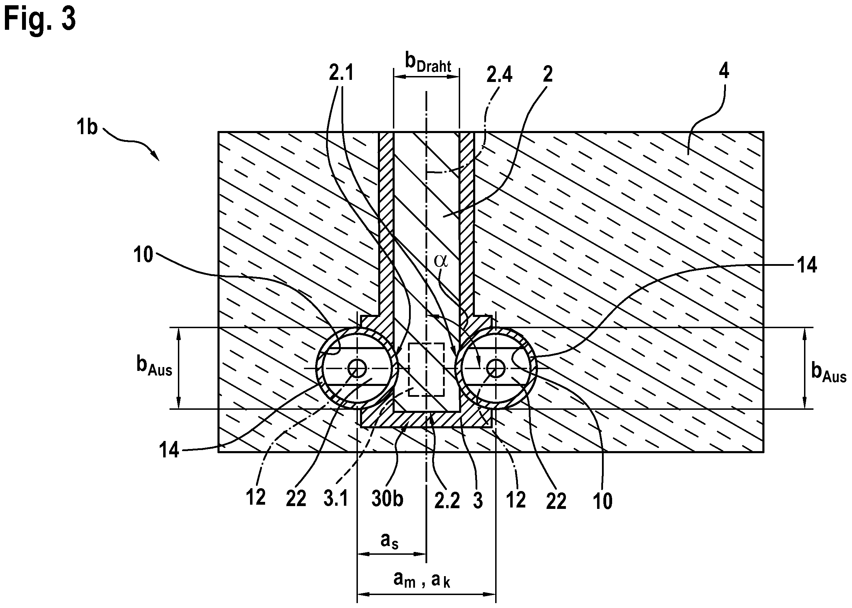

Bei dem in Fig. 3 dargestellten zweiten Ausführungsbeispiel des Schaltungsträgers 1b ist der innenliegende Draht 2 an einem Endbereich 2.2 des Drahts 2 freigelegt. Das bedeutet, dass der dargestellte Schaltungsträger 1b eine Kontaktanordnung 30b aufweist, deren Aussparungen 10 am Endbereich 2.2 des innenliegenden Drahts 2 angeordnet sind. Die Aussparungen 10 sind analog zum ersten Ausführungsbeispiel mit einem Ausrichtwinkel $\alpha$ von 90° zwischen der Sollmittellinie 2.4 und der direkten Verbindungslinie zwischen den Mittelachsen 12 der Aussparungen 10 ausgerichtet und weisen einen minimalen Abstand $a_m$ zueinander auf.

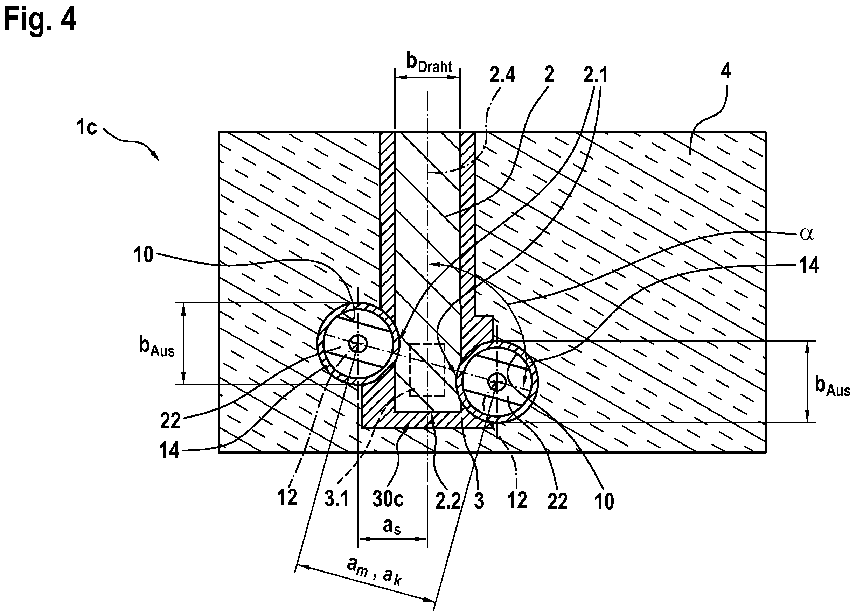

Das in Fig. 4 dargestellte dritte Ausführungsbeispiel des Schaltungsträgers 1c weist eine Kontaktanordnung 30c auf, deren Aussparungen 10 am Endbereich 2.2 des innenliegenden Drahts 2 mit einem Ausrichtwinkel $\alpha$ zwischen der Sollmittellinie 2.4 und der direkten Verbindungslinie zwischen den Mittelachsen 12 der Aussparungen 10 ausgerichtet sind, welcher größer als 90° ist. Der Abstand $a_m$ zwischen den Mittelachsen 12 der beiden Aussparungen 10 kann über den Ausrichtwinkel $\alpha$ an einen vorgegeben Abstand $a_k$ zwischen den Kontaktelementen 22 des Doppelpins 20 angepasst werden. Der Ausrichtwinkel $\alpha$ entspricht hierbei dem Winkel zwischen der Sollmittellinie 2.4 und der Verbindungslinie zwischen den Mittelachsen 12 der Aussparungen 10. Hierbei ist der Abstand $a_m$ zwischen den Mittelachsen 12 der mindestens zwei Aussparungen 10 bei vorgegeben Abstand $a_s$ zur Sollmittellinie 2.4 über den Ausrichtwinkel $\alpha$ variierbar, indem die Aussparungen 10 parallel zur Sollmittellinie 2.4 in entgegengesetzte Richtungen verschoben sind. Der Doppelpin 20 wird schräg ausgerichtet, so dass die Kontaktelemente 22 des Doppelpins 20 in die versetzten Aussparungen 10 der Kontaktanordnung 30c eingeführt werden können.

Das in Fig. 5 dargestellte vierte Ausführungsbeispiel des Schaltungsträgers 1d weist drei Drähte 2 auf, wobei beide Aussparungen 10 der Kontaktanordnung 30d zwischen zwei innenliegenden Drähten 2 angeordnet sind und beide Drähte 2 kontaktiert. Somit wird der Draht 2, welcher zwischen den beiden anderen Drähten 2 angeordnet ist, von außen über die Kontaktelemente 22 kontaktiert, wobei die äußeren Drähte 2 über jeweils eine Aussparung 10 und das korrespondierende Kontaktelement 22 mit dem mittleren Draht 2 verbunden werden.

Bei dem in Fig. 5 dargestellten vierten Ausführungsbeispiel des Schaltungsträgers 1d sind die Aussparungen 10 der Kontaktanordnung 30d am Endbereich 2.2 der innenliegenden Drähte 2 angeordnet. Die Aussparungen 10 sind analog zum ersten und zweiten Ausführungsbeispiel mit einem Ausrichtwinkel $\alpha$ von 90° zwischen der Sollmittellinie 2.4 des mittleren Drahtes 2 und der direkten Verbindungslinie zwischen den Mittelachsen 12 der Aussparungen 10 ausgerichtet und weisen einen minimalen Abstand $a_m$ zueinander auf.

In Fig.1 bis 5 ist der mehrlagige Schaltungsträger 1a, 1b, 1c, 1d jeweils nur mit einer Kontaktanordnung 30a, 30b, 30c, 30d dargestellt. Selbstverständlich kann der mehrlagige Schaltungsträger 1a, 1b, 1c, 1d eine beliebige Anzahl von Kontaktanordnungen 30a, 30b, 30c, 30d aufweisen.

Ausführungsformen der vorliegenden Erfindung stellen eine Kontaktanordnung für einen mehrlagigen Schaltungsträger zur Verfügung, welcher vorzugsweise für Hochstromanwendungen eingesetzt wird. Die erfindungsgemäße Kontaktanordnung ermöglicht eine einfache, zuverlässige und direkte Hochstromaußenkontaktierung an innenliegenden Drähten des Schaltungsträgers zur Zufuhr bzw. Abfuhr von hohen Strömen.

## Patentansprüche

1. Kontaktanordnung für einen mehrlagigen Schaltungsträger (1a, 1b, 1c, 1d), wobei der Schaltungsträger (1a, 1b, 1c, 1d) mindestens einen innenliegenden Draht (2) aufweist, welcher über mindestens eine Aussparung (10) kontaktiert ist, wobei mindestens zwei Aussparungen (10) auf verschiedenen Seiten des mindestens einen innenliegenden Drahts (2) angeordnet sind, wobei die Mittelachsen (12) der mindestens zwei Aussparungen (10) einen vorgegebenen Abstand ($a_s$) zu einer Sollmittellinie (2.4) des mindestens einen innenliegenden Drahts (2) aufweisen, wobei die mindestens zwei Aussparungen (10) den mindestens einen innenliegenden Draht (2) zur Kontaktierung freilegen, **dadurch gekennzeichnet, dass** jeweils ein Kontaktelement (22) innerhalb jeder Aussparung (10) angeordnet ist, und die mindestens zwei Aussparungen (10) den mindestens einen innenliegenden Draht (2) zur Kontaktierung an mindestens zwei Kontaktbereichen (2.1) freilegen, welche auf verschiedenen Seiten des Drahts (2) angeordnet sind, wobei das jeweilige Kontaktelement (22) in die korrespondierende Aussparung (10) eingepresst und/oder eingelötet ist.

2. Kontaktanordnung nach Anspruch 1, **dadurch gekennzeichnet, dass** der vorgegebene Abstand ($a_s$) der Mittelachsen (12) der mindestens zwei Aussparungen (10) zu einer Sollmittellinie (2.4) des mindestens einen innenliegenden Drahts (2) entsprechend einer Toleranzschwankung ($\Delta a$) des mindestens einen innenliegenden Drahts (2) zur Sollmittellinie (2.4) reduziert ist.

3. Kontaktanordnung nach Anspruch 1 oder 2, **dadurch gekennzeichnet, dass** der Abstand ($a_m$) zwischen den Mittelachsen (12) der mindestens zwei Aussparungen (10) bei vorgegebenem Abstand ($a_s$) zur Sollmittellinie (2.4) über einen Ausrichtwinkel ($\alpha$) variierbar ist.

4. Kontaktanordnung nach einem der Ansprüche 1 bis 3, **dadurch gekennzeichnet, dass** die Wandungen der Aussparungen (10) elektrisch leitfähig ausgeführt sind.

5. Kontaktanordnung nach einem der Ansprüche 1 bis 4, **dadurch gekennzeichnet, dass** die mindestens zwei Aussparungen (10) im Bereich eines Drahtendes (2.2) des mindestens einen innenliegenden Drahts (2) angeordnet sind.

6. Kontaktanordnung nach einem der Ansprüche 1 bis 5, **dadurch gekennzeichnet, dass** mindestens eine Aussparung (10) zwischen zwei innenliegenden Drähten (2) angeordnet ist und beide Drähte (2) kontaktiert.

7. Kontaktanordnung nach einem der Ansprüche 1 bis 6, **dadurch gekennzeichnet, dass** zwei Kontaktelemente (22) über einen Steg (24) miteinander verbunden sind und einen Doppelpin (20) ausbilden.

8. Kontaktanordnung nach Anspruch 7, **dadurch gekennzeichnet, dass** der Abstand ($a_m$) zwischen den Mittelachsen (12) der mindestens zwei Aussparungen (10) über den Ausrichtwinkel ($\alpha$) an einen vorgegeben Abstand ($a_k$) zwischen den Kontaktelementen (22) des Doppelpins (20) angepasst ist.

## Claims

1. Contact arrangement for a multi-layer circuit carrier (1a, 1b, 1c, 1d), wherein the circuit carrier (1a, 1b, 1c, 1d) comprises at least one inner-lying wire (2) that is contacted by way of at least one cut-out (10), wherein at least two cut-outs (10) are arranged on different sides of the at least one inner-lying wire (2), wherein the center axes (12) of the at least two cut-outs (10) comprise a predetermined spacing ($a_s$) with respect to a desired center line (2.4) of the at least one inner-lying wire (2), wherein the at least two cut-outs (10) expose the at least one inner-lying wire (2) to enable contact, **characterized in that** in each case a contact element (22) is arranged within each cut-out (10), and the at least two cut-outs (10) expose the at least one inner-lying wire (2) to enable contact with at least two contact regions (2.1) that are arranged on different sides of the wire (2), wherein the respective contact element (22) is force fitted and/or soldered into the corresponding cut-out (10) .

2. Contact arrangement according to Claim 1, **characterized in that** the predetermined spacing ($a_s$) of the center axes (12) of the at least two cut-outs (10) with respect to the desired center line (2.4) of the at least one inner-lying wire (2) is reduced corresponding to a tolerance deviation ($\Delta a$) of the at least one inner-lying wire (2) with respect to the desired center line (2.4).

3. Contact arrangement according to Claim 1 or 2, **characterized in that** the spacing ($a_m$) between the center axes (12) of the at least two cut-outs (10) can be varied in the case of the predetermined spacing ($a_s$) with respect to the desired center line (2.4) by way of an alignment angle ($\alpha$).

4. Contact arrangement according to any one of Claims 1 to 3, **characterized in that** the walls of the cut-outs (10) are embodied in an electrically conductive manner.

5. Contact arrangement according to any one of Claims 1 to 4, **characterized in that** the at least two cut-outs (10) are arranged in the region of a wire end (2.2) of the at least one inner-lying wire (2) .

6. Contact arrangement according to any one of Claims 1 to 5, **characterized in that** at least one cut-out (10) is arranged between two inner-lying wires (2) and contacts the two wires (2).

7. Contact arrangement according to any one of Claims 1 to 6, **characterized in that** two contact elements (22) are mutually connected by way of a connecting piece (24) and form a double pin (20).

8. Contact arrangement according to Claim 7, **characterized in that** the spacing ($a_m$) between the center axes (12) of the at least two cut-outs (10) is adjusted by way of the alignment angle ($\alpha$) to a predetermined spacing ($a_k$) between the contact elements (22) of the double pin (20).

**Revendications**

1. Dispositif de contact destiné à un support de circuit multicouche (1a, 1b, 1c, 1d), le support de circuit (1a, 1b, 1c, 1d) comportant au moins un fil intérieur (2) qui est contacté par le biais d'au moins un évidement (10), au moins deux évidements (10) étant disposés sur des côtés différents de l'au moins un fil intérieur (2), les axes centraux (12) des au moins deux évidements (10) étant placés à une distance prédéterminée ($a_s$) par rapport à une ligne médiane de consigne (2.4) de l'au moins un fil intérieur (2), les au moins deux évidements (10) exposant l'au moins un fil intérieur (2) en vue du contact, **caractérisé en ce qu'**un élément de contact (22) est disposé à l'intérieur de chaque évidement (10) et les au moins deux évidements (10) exposant l'au moins un fil intérieur (2) en vue du contact avec au moins deux zones de contact (2.1) qui sont disposées sur des côtés différents du fil (2), l'élément de contact respectif (22) étant enfoncé et/ou soudé dans l'évidement correspondant (10).

2. Dispositif de contact selon la revendication 1, **caractérisé en ce que** la distance prédéterminée ($a_s$) des axes centraux (12) des au moins deux évidements (10) par rapport à une ligne médiane de consigne (2.4) de l'au moins un fil intérieur (2) est réduite conformément à une variation de tolérance ($\Delta a$) de l'au moins un fil intérieur (2) par rapport à la ligne médiane de consigne (2.4).

3. Dispositif de contact selon la revendication 1 ou 2, **caractérisé en ce que**, pour une distance prédéterminée ($a_s$) à la ligne médiane de consigne (2.4), la distance ($a_m$) entre les axes centraux (12) des au moins deux évidements (10) peut être modifiée par le biais d'un angle d'orientation ($\alpha$).

4. Dispositif de contact selon l'une des revendications 1 à 3, **caractérisé en ce que** les parois des évidements (10) sont conçues pour être électriquement conductrices.

5. Dispositif de contact selon l'une des revendications 1 à 4, **caractérisé en ce que** les au moins deux évidements (10) sont disposés dans la région d'une extrémité de fil (2.2) de l'au moins un fil intérieur (2).

6. Dispositif de contact selon l'une des revendications 1 à 5, **caractérisé en ce qu'**au moins un évidement (10) est ménagé entre deux fils intérieurs (2) et les deux fils (2) sont mis en contact.

7. Dispositif de contact selon l'une des revendications 1 à 6, **caractérisé en ce que** deux éléments de contact (22) sont reliés entre eux par le biais d'une nervure (24) et forment une double goupille (20) .

8. Dispositif de contact selon la revendication 7, **caractérisé en ce que** la distance ($a_m$) entre les axes centraux (12) des au moins deux évidements (10) est adaptée par le biais de l'angle d'orientation ($\alpha$) à une distance prédéterminée ($a_k$) entre les éléments de contact (22) de la double goupille (20).

Fig. 1

EP 2 932 803 B1

**Fig. 2**

**Fig. 3**

EP 2 932 803 B1

Fig. 4

# Fig. 5

EP 2 932 803 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4500389 A
- DE 10108168 C1